# EUROPÄISCHE PATENTSCHRIFT

(11) **EP 3 028 140 B1**
(45) Veröffentlichungstag und Bekanntmachung des Hinweises auf die Patenterteilung: **02.08.2017**
(21) Anmeldenummer: 14772301.9
(22) Anmeldetag: 17.09.2014
(51) Int. Cl.: G06F 7/58

(54) **KONSTRUIEREN EINER SCHALTUNG GEEIGNET ZUR ERZEUGUNG VON ZUFALLSBITS UND SCHALTUNG ZUR ERZEUGUNG VON ZUFALLSBITS**
DESIGN OF A CIRCUIT SUITABLE FOR GENERATING RANDOM BITS AND CIRCUIT FOR GENERATING RANDOM BITS
CONSTRUCTION D'UN CIRCUIT APPROPRIÉ POUR GÉNÉRER DES BITS ALÉATOIRES ET CIRCUIT DE GÉNÉRATION DE BITS ALÉATOIRES

(30) Priorität: 31.10.2013 DE 102013222218
(43) Veröffentlichungstag der Anmeldung: 08.06.2016
(73) Patentinhaber: Siemens Aktiengesellschaft, 80333 München (DE)
(72) Erfinder: BÖFFGEN, Pascale, 81247 München (DE); DICHTL, Markus, 80636 München (DE)
(86) Internationale Anmeldenummer: PCT/EP2014/069756
(87) Internationale Veröffentlichungsnummer: WO 2015/062780

(56) Entgegenhaltungen:
- EP-A1- 1 643 643
- EP-A2- 2 799 980
- WO-A1-2014/177300
- US-B1- 8 099 449

## Beschreibung

Die Erfindung betrifft ein Verfahren und eine Vorrichtung zum Konstruieren einer Schaltung geeignet zur Erzeugung von Zufallsbits und eine Schaltung zur Erzeugung von Zufallsbits. Es wird zum Beispiel eine Zufallsbitfolge erzeugt, welche als binäre Zufallszahl verwendet wird. Das vorgeschlagene Verfahren und die Vorrichtung sowie die Schaltung dienen beispielsweise der Implementierung von Zufallszahlengeneratoren.

In sicherheitsrelevanten Anwendungen, beispielsweise bei asymmetrischen Authentifikationsverfahren, sind Zufallsbitfolgen als binäre Zufallszahlen notwendig. Dabei ist es gewünscht, insbesondere bei mobilen Anwendungen einen möglichst geringen Hardwareaufwand zu betreiben. Bekannte Maßnahmen, um Zufallszahlen zu erzeugen, verwenden analoge Zufallsquellen.

Als analoge Zufallsquellen werden Rauschquellen, wie z.B. das Rauschen von Zenerdioden, verstärkt und digitalisiert. Dabei wird digitale mit analoger Schaltungstechnik verbunden.

Ferner werden Ringoszillatoren und deren Abwandlungen als Zufallszahlengeneratoren verwendet. Bei Ringoszillatoren, die aus einer ungeraden Anzahl von hintereinander geschalteten Invertern aufgebaut sind, ergibt sich beispielsweise ein zufälliger Jitter aus schwankenden Durchlaufzeiten der Signale durch die Inverter. Dieser Jitter, also eine unregelmäßige zeitliche Schwankung in Zustandsänderungen der durch die Inverter geschickten Signale, kann bei mehrfachen Durchläufen durch die Ringoszillatorschaltung akkumuliert werden, so dass letztlich ein zufälliges analoges Signal entsteht.

Der Anmelderin ist ein sogenannter Mehrspurringoszillator bekannt geworden. Demgemäß wird eine Vorrichtung zum Erzeugen von Zufallsbits vorgeschlagen, die umfasst: mehrere Abbildungseinrichtungen, wobei eine jeweilige Abbildungseinrichtung eingerichtet ist, eine vorgegebene Anzahl n Eingangssignale mit Hilfe einer kombinatorischen Abbildung in eine vorgegebene Anzahl p Ausgangssignale abzubilden. Dabei sind die Abbildungseinrichtungen miteinander verkettet, und es ist mindestens eine Rückkopplungsschleife ausgebildet. Die Rückkopplungsschleife ist insbesondere derart ausgebildet, dass eine Zustandsänderung mindestens eines Ausgangssignals einer ausgewählten Abbildungseinrichtung als eine Zustandsänderung mindestens eines Eingangssignals einer anderen Abbildungseinrichtung zugeführt ist.

Vorzugsweise ist die andere Abbildungseinrichtung keine direkt benachbarte Abbildungseinrichtung.

Dabei liegt insbesondere eine Rückkopplungsschleife derart vor, dass eine Zustandsänderung mindestens eines Rückkopplungsausgangssignals einer bestimmten Abbildungseinrichtung als eine Zustandsänderung mindestens eines Eingangssignals einer anderen Abbildungseinrichtung derart zugeführt ist, dass eines oder mehrere Ausgangssignale der bestimmten Abbildungseinrichtung von der Zustandsänderung des Rückkopplungsausgangssignals beeinflusst wird.

Ferner ist mindestens eine kombinatorische Abbildung derart eingerichtet, dass eine Zustandsänderung eines Eingangssignals einer jeweiligen Abbildungseinrichtung im Mittel auf mehr als ein Ausgangssignal der jeweiligen Abbildungseinrichtung abgebildet wird.

Die Anzahl der n Eingangssignale einer jeweiligen Abbildungseinrichtung kann der Anzahl p der Ausgangssignale entsprechen. Es ist aber auch denkbar, dass n ungleich p ist, also dass mit Hilfe einer jeweiligen Abbildungseinrichtung die Zustände der Eingangssignale auf Zustände von Ausgangssignalen abgebildet werden, wobei die Anzahl der Ausgangssignale kleiner oder größer als die Anzahl der Eingangssignale für eine jeweilige Abbildungseinrichtung ist.

Die Abbildungseinrichtungen können logische oder kombinatorische Gatter sein, die insbesondere eine bijektive Abbildung von n Eingangssignalen auf n Ausgangssignale realisieren. Die Eingangssignale schwanken zwischen Pegeln, die logischen Zuständen, wie Bits 1 bzw. High oder 0 bzw. Low zugeordnet werden können. Unter einer bijektiven Abbildung versteht man eine eineindeutige Abbildung zwischen den 2ⁿ möglichen logischen Werten der Eingangssignale und den 2ⁿ logischen Werten der Ausgangssignale.

Insofern ergibt sich mit Hilfe der Abbildungseinrichtungen in Ausführungsformen der Vorrichtung ein n-Spur-Ringoszillator. Die Abbildungseinrichtungen können auch als Knoten oder Gatter bezeichnet sein. Die jeweilige kombinatorische Abbildung ist insbesondere derart eingerichtet, dass im Mittel bei einer Zustandsänderung eines Eingangssignals an mehr als einem Ausgangssignal ein Zustandswechsel erfolgt. Das führt dazu, dass ein jeweiliger Jitter des Eingangssignals auf mehrere Ausgangssignale abgebildet wird und daher verstärkt wird. Ein einmal aufgetretener Jitter in einem Signal wird mit Hilfe der Abbildungseinrichtungen bzw. der darin implementierten kombinatorischen Abbildungen auf mehrere Ausgangsspuren kopiert, so dass sich Jitter-Komponenten kaum kompensieren können.

Man kann bei der Vorrichtung auch von einer Mehrspur-Ringoszillatorschaltung sprechen. Gegenüber klassischen einspurigen Ringoszillatoren besteht insbesondere der Vorteil, dass mit einer höheren Datenrate zufällige Bitwerte abgegriffen werden können. Beispielsweise kann ein Zufallsbitsignal an einem oder mehreren der Datenpfade, welche sich durch die n Ein- bzw. Ausgangssignale ergeben, abgeleitet werden.

Man kann sagen, die Vorrichtung entwickelt "Schwingungen" oder Signalwechsel propagieren im Kreis. Vorzugsweise hängt mindestens eines der Ausgangssignale kausal von sich selbst ab, indem es rückgekoppelt wird, wobei die Rückkopplung mit Hilfe mindestens einer zwischengeschalteten Abbildung erfolgt.

Für einen solchen Mehrspurringoszillator ist es besonders vorteilhaft, dass er keinen Fixpunkt aufweist. Denn die Existenz eines Fixpunktes kann dazu führen, dass der Ring in einen schwingungsfreien stationären Zustand kommt, so dass keine weiteren Zufallsbits erzeugt werden können.

Es ist aus dem Stand der Technik bekannt, so lange zufällig eine Ringschaltung mit einer bestimmten Länge zu erzeugen, bis ein fixpunktfreier Mehrspurringoszillator gefunden ist.

Die Patentschrift US 8099449 B1 offenbart eine Methode zur Erzeugung von Zufallszahlen mittels einer Multiplizierer Schwingung mit einem Multipliziererschaltkreis zum Empfangen von asynchronen Eingangssignalen, wobei eines erstes Eingangssignal ein Rückkopplungssignal auf Basis eines Ausgangs des Multiplizieres ist.

Vor diesem Hintergrund besteht die Aufgabe der vorliegenden Erfindung darin, ein verbessertes Verfahren und eine Vorrichtung zum Konstruieren komplexer und / oder flexibler Schaltungen bereitzustellen.

Diese Aufgabe wird erfindungsgemäß durch ein Verfahren, eine Vorrichtung und eine Schaltung gemäß den in den unabhängigen Ansprüchen angegebenen Merkmalen gelöst. Weitere vorteilhafte Ausgestaltungen der Erfindung sind in den abhängigen Ansprüchen angegeben.

Es wird ein Verfahren zum Konstruieren einer Schaltung geeignet zur Erzeugung von Zufallsbits vorgeschlagen, wobei
- die Schaltung eine Anzahl m an Abbildungseinrichtungen aufweist;
- jeder der Abbildungseinrichtungen eine Anzahl n an Eingangsbits zugeführt wird, wobei n ein Wert größer 1 ist;
- durch jede der Abbildungseinrichtungen mittels einer jeweiligen Funktion eine bijektive Abbildung der n Eingangsbits auf n Ausgangsbits ausgeführt wird,
   aufweisend folgende Schritte:
   (a) Auswählen einer j-ten Abbildungseinrichtung aus der ersten Abbildungseinrichtung bis m-ten Abbildungseinrichtung und Vorgeben einer j-ten spezifischen Funktion aus einer Menge von bijektiven Abbildungen als j-te Funktion, wobei
- durch eine j-te Verkettung der j Funktionen bei dem Vorgeben der j-ten spezifischen Funktion als j-te Funktion eine j-te fixpunktfreie Abbildung ausgeführt wird;
- durch die j-te Verkettung die j Funktionen in einer aufsteigenden Reihenfolge startend mit der ersten Funktion angewendet werden;
   (b) Auswählen mindestens einer i-ten Abbildungseinrichtung aus der ersten Abbildungseinrichtung bis m-ten Abbildungseinrichtung, wobei i ungleich j ist, und Vorgeben einer i-ten spezifischen Funktion aus einer Menge von bijektiven Abbildungen als i-te Funktion, wobei
- durch eine i-te Verkettung der i Funktionen bei dem Vorgeben der i-ten spezifischen Funktion als i-te Funktion eine i-te fixpunktfreie Abbildung ausgeführt wird;
- durch die i-te Verkettung die i Funktionen in einer aufsteigenden Reihenfolge startend mit der ersten Funktion angewendet werden.

Es laufen also beispielsweise n Signale durch eine ringförmige Schaltung mit m Abbildungseinrichtungen, auch Knoten genannt. Jeder Knoten ist aus logischen Gattern aufgebaut. Jeder Knoten hat n Input- und Outputbits. Die Knoten sind so gewählt, dass ihre Abbildung der n Inputbits auf die n Outputbits eine bijektive Abbildung oder Bijektion darstellt, d. h. wenn die Inputs alle möglichen 2ⁿ Werte annehmen, nehmen auch die Outputs alle möglichen 2ⁿ Werte an, allerdings im Allgemeinen in anderer Reihenfolge.

Es handelt sich insbesondere bei der Schaltung um einen Mehrspurringoszillator. Insbesondere führt eine Zustandsänderung eines Eingangssignals einer jeweiligen Abbildungseinrichtung im Mittel zu einer Änderung in mehr als einem Ausgangssignal.

Um sicherzustellen, dass eine solche ringförmige Schaltung - kurz Ring genannt - fortwährend schwingt, darf die Schaltung keinen Fixpunkt haben. Um den Sachverhalt des Fixpunktes genauer zu beschreiben, trennt man den Ring an einer beliebigen aber festen Stelle zwischen den Knoten auf.

Dann liegt eine Schaltung vor mit n Inputbits, die über m Knoten, von denen jeder eine bijektive Abbildung fᵢ für einen Index i von den Werten 1 bis m von n Eingangsbits auf n Ausgangsbits ausführt, nach dem m-ten Knoten n Outputbits liefert.

Insbesondere ist eine m-te Abbildung oder Gesamtabbildung fₘ' des aufgetrennten Ringes gegeben durch eine m-te Verkettung fₘ'=fₘ°fₘ₋₁°fₘ₋₂°...°f₂°f₁ wobei in der vorliegenden Anmeldung eine Verkettung von Funktionen von rechts nach links zu lesen ist, d. h. zuerst wird f₁ angewendet, dann f₂, usw. Anwenden heißt dabei, dass die erste Funktion f₁ auf ein erstes Eingangstupel an der ersten Abbildungseinrichtung, das aus den n Eingangsbits gebildet wird, angewendet wird, d.h. das erste Eingangstupel nach einer Abbildungsvorschrift der ersten Funktion auf ein erstes Ausgangstupel abgebildet wird. Die zweite Funktion wird insbesondere auf das erste Ausgangstupel angewendet, das damit ein zweites Eingangstupel für die zweite Abbildungseinrichtung bildet. Die zweite Abbildungseinrichtung liefert dann ein zweites Ausgangstupel. Eine dritte Funktion wird dann beispielsweise auf das zweite Ausgangstupel angewendet usw.

Der gesamte Ring ist genau dann fixpunktfrei, wenn für alle möglichen n-Tupel x als erste Eingangstupel gilt fₘ'(x) ≠ x.

In Worten heißt das, dass für alle möglichen n-Tupel x das erste Eingangstupel nicht gleich dem m-ten Ausgangstupel an der m-ten Abbildungseinrichtung ist.

Erfindungsgemäß wird als j-te Funktion der j-ten Abbildungseinrichtung eine j-te spezifische Funktion aus einer Menge von bijektiven Abbildungen ausgewählt, so dass durch eine j-te Verkettung der j Funktionen eine j-te fixpunktfreie Abbildung ausgeführt wird. Es werden so lange Bijektionen von n auf n Bits als Kandidaten für die j-te Funktion ausgesucht, bis eine j-te spezifische Funktion gefunden ist, die die Bedingung erfüllt, dass die Verkettung aller vorherigen Funktionen im Ring bis zur j-ten Funktion fixpunktfrei ist, und diese wird als j-te Funktion verwendet. Beispielsweise kann das Aussuchen der j-ten Funktion zufällig erfolgen.

Dann wird mindestens eine i-te Abbildungseinrichtung ausgewählt aus der ersten bis m-ten Abbildungseinrichtung, wobei i ungleich j ist. Der i-ten Funktion wird eine i-te spezifische Funktion aus einer Menge von bijektiven Abbildungen zugeordnet, so dass durch eine i-te Verkettung der i Funktionen eine i-te fixpunktfreie Abbildung ausgeführt wird.

Auch dabei werden so lange Bijektionen von n auf n Bits als Kandidaten für die i-te Funktion untersucht, bis für alle möglichen n-Tupel x das Anwenden der Verkettung der ersten bis i-ten Funktion auf das erste Eingangstupel ein i-tes Ausgangstupel liefert, das ungleich dem ersten Eingangstupel ist. Beispielsweise kann das Aussuchen der i-ten Funktion zufällig erfolgen.

Es wird dabei also die Abbildung des ersten Eingangstupels auf das i-te Ausgangstupel, d.h. die i-te Verkettung der ersten bis i-ten Funktion, auf fixpunktfreie Eigenschaft untersucht. Es kann also insbesondere eine Teilverkettung innerhalb der Schaltung betrachtet werden.

Das beschriebene Verfahren ermöglicht eine effiziente Konstruktion beliebig langer und flexibel kürzbarer ringförmiger Schaltungen zur Erzeugung von Zufallsbits.

Die gemäß dem beschriebenen Verfahren konstruierte Schaltung ermöglicht das flexible Umschalten der Rückkopplung vom Ausgang der j-ten Abbildungseinrichtung zum Eingang der ersten Abbildungseinrichtung auf eine Rückkopplung vom Ausgang der i-ten Abbildungseinrichtung zum Eingang der ersten Abbildungseinrichtung. Dabei entstehen mit beiden Rückkopplungen fixpunktfreie Ringe.

Gemäß einer Weiterbildung wird aufbauend auf dem oben beschriebenen Konstruktionsverfahren jede der m-1 Abbildungseinrichtungen aus der ersten Abbildungseinrichtung bis m-ten Abbildungseinrichtung ausgewählt und eine jeweilige spezifische Funktion der jeweiligen Funktion zugeordnet, so dass jede Verkettung fⱼ'= fⱼ°...°f₁ für alle j von 1 bis m einschließlich 1 und m eine fixpunktfreie Abbildung des ersten Eingangstupels darstellt. Für die erste Funktion f₁ ist es dabei ausreichend, eine fixpunktfreie Funktion zu wählen, da für das Erstellen des ersten Ausgangstupel keine Verkettung angewendet wird. Damit ist eine besonders große Flexibilität bei der Kürzung der Schaltung gegeben.

Die so konstruierte Schaltung ermöglicht die Verwendung eines Ringoszillators oder Mehrspurringoszillators mit flexibler Länge. Es ist möglich, aus dem mit dem beschriebenen Verfahren konstruierten fixpunktfreien Ring, ohne zusätzliche Gatter zu benötigen, fixpunktfreie Ringe variabler Länge zu konstruieren. Beispielsweise erhält man durch Rückkoppeln der Outputbits eines beliebigen i-ten Knotens aus den m Knoten an die Eingänge des ersten Knotens fixpunktfreie Ringe der Länge i, also Längen mit Werten von 1 bis m.

Für einen zufällig gewählten Ring mit beispielsweise 100 Knoten und je 4 Eingangs- und Ausgangsbits ist die Wahrscheinlichkeit, einen fixpunktfreien Ring zu erhalten, der auch auf beliebige Längen gekürzt werden kann und dabei seine fixpuntkfreie Eigenschaft behält, nur etwa 2,53·10⁻⁴³. Ein solches Verfahren wäre nicht praktikabel. Dagegen wird gemäß dem beschriebenen Verfahren eine effiziente iterative Lösung angegeben.

Das beschriebene iterative Verfahren wird nur einmalig bei der Konstruktion des Ringes angewendet. Spätere Umbauten, welche den Ring beispielsweise von einer Länge von j Abbildungseinrichtungen, wobei j zwischen 1 und m liegt oder m sein kann, auf i Abbildungseinrichtungen verkürzen mit i größer oder gleich 1 und kleiner j, verursachen vorteilhafterweise keinen erneuten Aufwand, um das Vorliegen eines fixpunktfreien Oszillators sicherzustellen.

Gemäß einer Ausgestaltung wird die Schaltung als Mehrspurringoszillator ausgebildet. Dies ermöglicht das effiziente Konstruieren einer fixpunktfreien Schaltung, bei der eine große Anzahl n als Eingangsbits je Abbildungseinrichtung vorliegt und eine variable Rückkopplung zu der ersten Abbildungseinrichtung möglich sein soll, so dass auch der durch die Rückkopplung gekürzte Ring fixpunktfrei ist.

Die Erfindung betrifft ferner eine Vorrichtung zum Konstruieren einer Schaltung geeignet zur Erzeugung von Zufallsbits, wobei
- die Schaltung eine Anzahl m an Abbildungseinrichtungen aufweist;
- jede der Abbildungseinrichtungen eine Anzahl n an Eingangsbits erhält, wobei n ein Wert größer 1 ist;
- durch jede der Abbildungseinrichtungen mittels einer jeweiligen Funktion eine bijektive Abbildung der n Eingangsbits auf n Ausgangsbits ausführbar ist,
   umfassend:
   eine j-te Einheit
   zum Auswählen einer j-ten Abbildungseinrichtung aus der ersten Abbildungseinrichtung bis m-ten Abbildungseinrichtung und
   zum Vorgeben einer j-ten spezifischen Funktion aus einer Menge von bijektiven Abbildungen als j-te Funktion, wobei
   durch eine j-te Verkettung der j Funktionen bei dem Vorgeben der j-ten spezifischen Funktion als j-te Funktion eine j-te fixpunktfreie Abbildung ausführbar ist und
   durch die j-te Verkettung die j Funktionen in einer aufsteigenden Reihenfolge startend mit der ersten Funktion anwendbar sind;
- eine i-te Einheit
   zum Auswählen mindestens einer weiteren i-ten Abbildungseinrichtung aus der ersten Abbildungseinrichtung bis m-ten Abbildungseinrichtung, wobei i ungleich j ist, und
   zum Vorgeben einer i-ten spezifischen Funktion aus einer Menge von bijektiven Abbildungen als i-te Funktion, wobei
   durch eine i-te Verkettung der i Funktionen bei dem Vorgeben der i-ten spezifischen Funktion als i-te Funktion eine i-te fixpunktfreie Abbildung ausführbar ist und
   durch die i-te Verkettung die i Funktionen in einer aufsteigenden Reihenfolge startend mit der ersten Funktion anwendbar sind.

Mit Hilfe der vorgeschlagenen Vorrichtung wird eine Schaltung ermittelt, die flexibel im Einsatz ist. Es können ohne Mehraufwand an Gattern innerhalb der Schaltung durch geeignetes Umschalten der Verbindungsleitungen fixpunktfreie Ringe variabler Länge erzeugt werden. Mit einem mit Hilfe der vorgeschlagenen Vorrichtung ermittelten Ring der Länge m stehen flexibel auch geeignete Ringe kleinerer Längen zur Verfügung.

Die j-te Einheit und i-te Einheit können hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Die Erfindung betrifft ferner eine Schaltung zur Erzeugung von Zufallsbits, wobei
- die Schaltung eine Anzahl m an Abbildungseinrichtungen aufweist;
- jede der Abbildungseinrichtungen eine Anzahl n an Eingangsbits erhält, wobei n ein Wert größer 1 ist;
- durch jede der Abbildungseinrichtungen mittels einer jeweiligen Funktion eine bijektive Abbildung der n Eingangsbits auf n Ausgangsbits ausführbar ist;
- eine j-te Abbildungseinrichtung aus der ersten Abbildungseinrichtung bis m-ten Abbildungseinrichtung auswählbar ist und als die j-te Funktion eine j-te spezifische Funktion aus einer Menge von bijektiven Abbildungen vorgebbar ist, wobei
   durch eine j-te Verkettung der j Funktionen bei dem Vorgeben der j-ten spezifischen Funktion als j-te Funktion eine j-te fixpunktfreie Abbildung ausführbar ist und
   durch die j-te Verkettung die j Funktionen in einer aufsteigenden Reihenfolge startend mit der ersten Funktion anwendbar sind;
- mindestens eine weitere i-te Abbildungseinrichtung aus der ersten Abbildungseinrichtung bis m-ten Abbildungseinrichtung, wobei i ungleich j ist, auswählbar ist und als i-te Funktion eine i-te spezifische Funktion aus einer Menge von bijektiven Abbildungen vorgebbar ist, wobei
   durch eine i-te Verkettung der i Funktionen bei dem Vorgeben der i-ten spezifischen Funktion als i-te Funktion eine i-te fixpunktfreie Abbildung ausführbar ist und
   durch die i-te Verkettung die i Funktionen in einer aufsteigenden Reihenfolge startend mit der ersten Funktion anwendbar sind.

Die vorgeschlagene Schaltung oder den vorgeschlagenen Ring der Länge m kann man, ohne zusätzliche Gatter zu benötigen, flexibel kürzen. Es kann zwischen einer Rückkopplung vom Ausgang der j-ten Abbildungseinrichtung zum Eingang der ersten Abbildungseinrichtung auf eine Rückkopplung vom Ausgang der i-ten Abbildungseinrichtung zum Eingang der ersten Abbildungseinrichtung umgeschaltet werden. Beide erzeugten Ringe sind fixpunktfrei.

Die Länge des Ringes flexibel zu halten kann insbesondere sinnvoll sein, um den Stromverbrauch des Ringes beeinflussen zu können. Ein weiterer Vorteil von Ringen variabler Länge ist, dass man, da sehr kurze Mehrspur-Ringoszillatoren zu periodischem statt chaotischem Schwingen neigen, mit einem erfindungsgemäßen Ring einen kurzen Ring aussuchen kann, bei dem chaotisches Schwingen auftritt, ohne die logischen Funktionen zu ändern.

Die Erfindung wird im Nachfolgenden mit einem Ausführungsbeispiel anhand einer Figur näher erläutert.

Es zeigt:

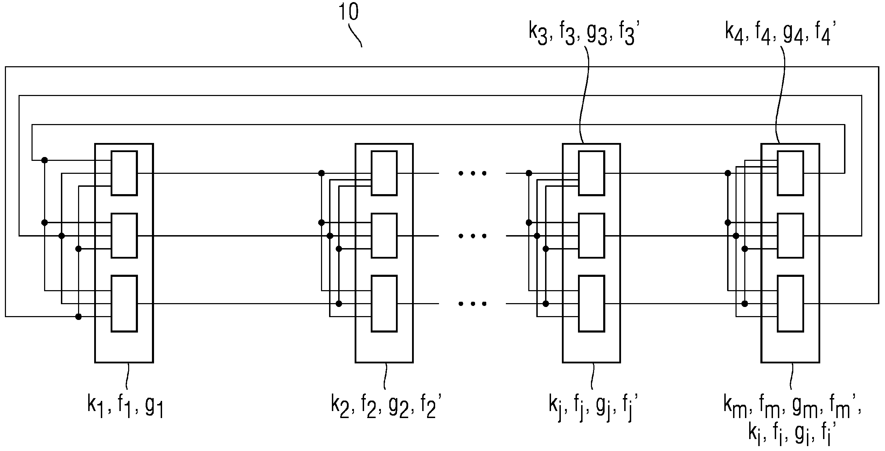

Figur 1 eine schematische Darstellung einer Schaltung gemäß einem Ausführungsbeispiel der Erfindung.

In der Figur ist eine Schaltung 10 mit einer Anzahl m, m=4, an Abbildungseinrichtungen K₁, K₂, K₃ = Kⱼ, K₄ = Kᵢ = Kₘ dargestellt.

Beispielshalber wird eine Schaltung der Länge 4 generiert und diese zu einem Ring geschlossen. In der Figur ist ein Mehrspurringoszillator mit drei Spuren (n=3) dargestellt.

An der ersten Abbildungseinrichtung K₁ wird eine zufällige Bijektion als erste Funktion f₁ gewählt, so dass die erste Abbildung fixpunktfrei ist. Damit ist eine erste spezifische Funktion g₁ gefunden. An der zweiten Abbildungseinrichtung K₂ wird eine Bijektion als zweite Funktion f₂ gewählt, so dass die zweite Verkettung f₂' aus erster Funktion f₁ und zweiter Funktion f₂ fixpunktfrei ist. Damit ist eine zweite spezifische Funktion g₂ gefunden. Ebenso wird an der dritten Abbildungseinrichtung K₃ eine Bijektion als dritte Funktion f₃ gewählt, so dass die dritte Verkettung f₃' aus erster Funktion f₁, zweiter Funktion f₂ und dritter Funktion f₃ fixpunktfrei ist. Damit ist eine dritte spezifische Funktion g₃ gefunden. Ebenso wird an der vierten Abbildungseinrichtung K₄ eine Bijektion als vierte Funktion f₄ gewählt, so dass die vierte Verkettung f₄' aus erster Funktion f₁, zweiter Funktion f₂, dritter Funktion f₃ und vierter Funktion f₄ fixpunktfrei ist. Damit ist eine vierte spezifische Funktion g₄ gefunden.

Das nachfolgende VHDL-Fragment zeigt, wie ein 4-Spur-Ring der Länge 4 aus Spartan-3 Look-Up-Tables, kurz LUTs, für einen Xilinx-Chip aufgebaut ist. Jede der Abbildungseinrichtungen K₁, K₂, K₃, K₄ besteht aus 4 LUTs, wobei jede LUT die 4 Inputbits auf ein Outputbit abbildet. Die Abbildung an jeder Abbildungseinrichtung K₁, K₂, K₃, K₄ ist eine Bijektion von der Menge aller Bit-4-Tupel auf die Menge aller Bit-4-Tupel.
-- LUT4: 4-input Look-Up Table with general output
-- Spartan-3
-- Xilinx HDL Libraries Guide, version 12.2

LUT0inst:LUT4
   generic map (INIT=>x"c92e")
   port map
   (O=>ausgang (4), I0=>ausgang (0), I1=>ausgang (1), I2=>ausgang (2), I 3=>ausgang (3));
LUT1inst:LUT4
   generic map (INIT=>x"a8da")
   port map
   (O=>ausgang (5), I0=>ausgang (0), I1=>ausgang (1), I2=>ausgang (2), I 3=>ausgang (3));
LUT2inst:LUT4
   generic map (INIT=>x"b1a3")
   port map
   (O=>ausgang (6), I0=>ausgang (0), I1=>ausgang (1), I2=>ausgang (2), I 3=>ausgang (3));
LUT3inst:LUT4
   generic map (INIT=>x"44eb")
   port map
   (O=>ausgang (7), I0=>ausgang (0), I1=>ausgang (1), I2=>ausgang (2), I 3=>ausgang (3));
LUT4inst:LUT4
   generic map (INIT=>x"21b7")
   port map
   (O=>ausgang (8), I0=>ausgang (4), I1=>ausgang (5), I2=>ausgang (6), I 3=>ausgang (7));
LUT5inst:LUT4
   generic map (INIT=>x"7a23")
   port map
   (O=>ausgang (9), I0=>ausgang (4), I1=>ausgang (5), I2=>ausgang (6), I 3=>ausgang (7));
LUT6inst:LUT4
   generic map (INIT=>x"1d0f")
   port map
   (O=>ausgang (10), I0=>ausgang (4),I1=>ausgang (5), I2=>ausgang (6), I3=>ausgang (7));
LUT7inst:LUT4
   generic map (INIT=>x"cda2")
   port map
   (O=>ausgang (11), IO=>ausgang (4), I1=>ausgang (5), I2=>ausgang (6), I3=>ausgang(7));
LUT8inst:LUT4
   generic map (INIT=>x"6d2c")
   port map
   (O=>ausgang (12), IO=>ausgang (8), I1=>ausgang (9), I2=>ausgang (10) , I3=>ausgang (11));
LUT9inst:LUT4
   generic map (INIT=>x"5f81")
   port map
   (O=>ausgang (13), I0=>ausgang (8), I1=>ausgang (9), I2=>ausgang (10) , I3=>ausgang (11));
LUT10inst:LUT4
   generic map (INIT=>x"d8e8")
   port map
   (O=>ausgang (14), I0=>ausgang (8), I1=>ausgang (9), I2=>ausgang (10) , I3=>ausgang (11));
LUT11inst:LUT4
   generic map (INIT=>x"7658")
   port map
   (O=>ausgang(15), I0=>ausgang (8), I1=>ausgang (9), I2=>ausgang (10) , I3=>ausgang (11));
LUT12inst:LUT4
   generic map (INIT=>x"1c5e")
   port map
   (O=>ausgang(16), I0=>ausgang (12), I1=>ausgang (13), I2=>ausgang (1 4), I3=>ausgang (15));
LUT13inst:LUT4
   generic map (INIT=>x"16e9")
   port map
   (O=>ausgang (17), I0=>ausgang (12), I1=>ausgang (13), I2=>ausgang (1 4), I3=>ausgang (15));
LUT14inst:LUT4
   generic map (INIT=>x"9353")
   port map
   (O=>ausgang (18), I0=>ausgang (12), I1=>ausgang (13), I2=>ausgang(1 4), I3=>ausgang (15)) ;
LUT15inst:LUT4
   generic map (INIT=>x"bc31")
   port map
   (O=>ausgang (19), I0=>ausgang (12), I1=>ausgang (13), I2=>ausgang(1 4), I3=>ausgang (15));

Die logische Funktion der LUT wird dabei als hexadezimaler Parameter in Form einer Wertetabelle von 16 Bits als sogenannter INIT-Parameter mitgegeben, z. B. INIT=>x"bc31" für die letzte LUT.

Mit den folgenden 4 Zuweisungen kann beispielsweise die Schaltung 10 zu einem fixpunktfreien Ring der Länge 4 mit der ersten Abbildungseinrichtung K1, der zweiten Abbildungseinrichtung K2, der dritten Abbildungseinrichtung K3 und der vierten Abbildungseinrichtung K4 gemacht werden:
ausgang (0) <= ausgang(16);
ausgang (1) <= ausgang(17);
ausgang(2)<= ausgang(18);
ausgang(3)<= ausgang(19);

Mit den folgenden 4 Zuweisungen kann beispielsweise die Schaltung 10 zu einem fixpunktfreien Ring der Länge 2 mit der ersten Abbildungseinrichtung K1 und der zweiten Abbildungseinrichtung K2 verkürzt werden:
ausgang (0) <= ausgang(8);
ausgang (1) <= ausgang(9);
ausgang(2)<= ausgang(10);
ausgang(3)<= ausgang(11);

So ist ein flexibles Umschalten zwischen den Längen 4 und 2 möglich.

Da dieses flexible Umschalten für beliebige Längen und für beliebige Kürzungen möglich ist, kann beispielsweise der Stromverbrauch durch das Umschalten deutlich reduziert werden und somit an Anforderungen an einen Zufallszahlengenerator je nach Einsatzgebiet angepasst werden, ohne dass eine Neu-Konstruktion der Schaltung 10 nötig wäre.

## Patentansprüche

1. Verfahren zum Konstruieren einer Schaltung (10) geeignet zur Erzeugung von Zufallsbits, wobei
- die Schaltung (10) eine Anzahl m an Abbildungseinrichtungen (K1, K2,... Kj,... Ki,... Km) aufweist;
- jeder der Abbildungseinrichtungen (K1, K2,... Kj,... Ki,... Km) eine Anzahl n an Eingangsbits zugeführt wird, wobei n ein Wert größer 1 ist;
- durch jede der Abbildungseinrichtungen (K1, K2,... Kj,... Ki,... Km) mittels einer jeweiligen Funktion (f₁, f₂,... fⱼ,... fᵢ,... fₘ) eine bijektive Abbildung der n Eingangsbits auf n Ausgangsbits ausgeführt wird,
aufweisend folgende Schritte:
(a) Auswählen einer j-ten Abbildungseinrichtung (Kⱼ) aus der ersten Abbildungseinrichtung (K₁) bis m-ten Abbildungseinrichtung (Kₘ) und Vorgeben einer j-ten spezifischen Funktion (gⱼ) aus einer Menge von bijektiven Abbildungen als j-te Funktion (fⱼ), wobei
- durch eine j-te Verkettung (fⱼ') der j Funktionen (f₁,... fⱼ) bei dem Vorgeben der j-ten spezifischen Funktion (gⱼ) als j-te Funktion (fⱼ) eine j-te fixpunktfreie Abbildung ausgeführt wird;
- durch die j-te Verkettung die j Funktionen in einer aufsteigenden Reihenfolge startend mit der ersten Funktion (f₁) angewendet werden;
(b) Auswählen mindestens einer i-ten Abbildungseinrichtung (Kᵢ) aus der ersten Abbildungseinrichtung (K₁) bis m-ten Abbildungseinrichtung (Kₘ), wobei i ungleich j ist, und Vorgeben einer i-ten spezifischen Funktion (gᵢ) aus einer Menge von bijektiven Abbildungen als i-te Funktion (fᵢ), wobei
- durch eine i-te Verkettung (fᵢ') der i Funktionen (f₁,... fᵢ) bei dem Vorgeben der i-ten spezifischen Funktion (gᵢ) als i-te Funktion (fᵢ) eine i-te fixpunktfreie Abbildung ausgeführt wird;
- durch die i-te Verkettung die i Funktionen in einer aufsteigenden Reihenfolge startend mit der ersten Funktion (f₁) angewendet werden.

2. Verfahren nach Anspruch 1, wobei
- jede der m Abbildungseinrichtungen aus der ersten Abbildungseinrichtung (K₁) bis m-ten Abbildungseinrichtung (Km) ausgewählt wird und gemäß den Schritten (a) oder (b) eine jeweilige spezifische Funktion (g₁, g₂,... gⱼ,... gᵢ,... gₘ) als jeweilige Funktion (f₁, f₂,... fⱼ,... fᵢ,... fₘ) vorgegeben wird.

3. Verfahren nach Anspruch 1 oder 2, wobei die Schaltung (10) als Mehrspurringoszillator ausgebildet wird.

4. Vorrichtung zum Konstruieren einer Schaltung (10) geeignet zur Erzeugung von Zufallsbits, wobei
- die Schaltung (10) eine Anzahl m an Abbildungseinrichtungen (K₁, K₂,... Kⱼ,... Kᵢ,... Kₘ) aufweist;
- jede der Abbildungseinrichtungen (K₁, K₂,... Kⱼ,... Kᵢ,... Kₘ) eine Anzahl n an Eingangsbits erhält, wobei n ein Wert größer 1 ist;
- durch jede der Abbildungseinrichtungen (K₁, K₂,... Kⱼ,... Kᵢ,... Kₘ) mittels einer jeweiligen Funktion (f₁, f₂,... fⱼ,... fᵢ,... fₘ) eine bijektive Abbildung der n Eingangsbits auf n Ausgangsbits ausführbar ist,
umfassend:
- eine j-te Einheit
zum Auswählen einer j-ten Abbildungseinrichtung (Kⱼ) aus der ersten Abbildungseinrichtung (K₁) bis m-ten Abbildungseinrichtung (Kₘ) und
zum Vorgeben einer j-ten spezifischen Funktion (gⱼ) aus einer Menge von bijektiven Abbildungen als j-te Funktion (fⱼ), wobei
durch eine j-te Verkettung (fⱼ') der j Funktionen (f₁,... fⱼ) bei dem Vorgeben der j-ten spezifischen Funktion (gⱼ) als j-te Funktion (fⱼ) eine j-te fixpunktfreie Abbildung ausführbar ist und
durch die j-te Verkettung die j Funktionen in einer aufsteigenden Reihenfolge startend mit der ersten Funktion (f₁) anwendbar sind;
- eine i-te Einheit
zum Auswählen mindestens einer weiteren i-ten Abbildungseinrichtung (Kᵢ) aus der ersten Abbildungseinrichtung (K₁) bis m-ten Abbildungseinrichtung (Kₘ), wobei i ungleich j ist, und
zum Vorgeben einer i-ten spezifischen Funktion (gᵢ) aus einer Menge von bijektiven Abbildungen als i-te Funktion (fᵢ), wobei
durch eine i-te Verkettung (fᵢ') der i Funktionen (f₁,... fᵢ) bei dem Vorgeben der i-ten spezifischen Funktion (gᵢ) als i-te Funktion (fᵢ) eine i-te fixpunktfreie Abbildung ausführbar ist und
durch die i-te Verkettung die i Funktionen in einer aufsteigenden Reihenfolge startend mit der ersten Funktion (f₁) anwendbar sind.

5. Schaltung (10) zur Erzeugung von Zufallsbits, wobei
- die Schaltung (10) eine Anzahl m an Abbildungseinrichtungen (K₁, K₂,... Kⱼ,... Kᵢ,... Kₘ) aufweist;
- jede der Abbildungseinrichtungen (K₁, K₂,... Kⱼ,... Kᵢ,... Kₘ) eine Anzahl n an Eingangsbits erhält, wobei n ein Wert größer 1 ist; **dadurch gekennzeichnet, dass**
- durch jede der Abbildungseinrichtungen (K₁, K₂,... Kⱼ,... Kᵢ,... Kₘ) mittels einer jeweiligen Funktion (f₁, f₂,... fⱼ,... fᵢ,... fₘ) eine bijektive Abbildung der n Eingangsbits auf n Ausgangsbits ausführbar ist;
- eine j-te Abbildungseinrichtung (Kⱼ) aus der ersten Abbildungseinrichtung (K₁) bis m-ten Abbildungseinrichtung (Kₘ) auswählbar ist und als die j-te Funktion (fⱼ) eine j-te spezifische Funktion (gⱼ) aus einer Menge von bijektiven Abbildungen vorgebbar ist, wobei
durch eine j-te Verkettung (fⱼ') der j Funktionen (f₁,... fⱼ) bei dem Vorgeben der j-ten spezifischen Funktion (gⱼ) als j-te Funktion (fⱼ) eine j-te fixpunktfreie Abbildung ausführbar ist und
durch die j-te Verkettung die j Funktionen in einer aufsteigenden Reihenfolge startend mit der ersten Funktion (f₁) anwendbar sind;
- mindestens eine weitere i-te Abbildungseinrichtung (Kᵢ) aus der ersten Abbildungseinrichtung (K₁) bis m-ten Abbildungseinrichtung (Kₘ), wobei i ungleich j ist, auswählbar ist und als i-te Funktion (fᵢ) eine i-te spezifische Funktion (gᵢ) aus einer Menge von bijektiven Abbildungen vorgebbar ist, wobei
durch eine i-te Verkettung (fᵢ') der i Funktionen (fᵢ,... fᵢ) bei dem Vorgeben der i-ten spezifischen Funktion (gᵢ) als i-te Funktion (fᵢ) eine i-te fixpunktfreie Abbildung ausführbar ist und
durch die i-te Verkettung die i Funktionen in einer aufsteigenden Reihenfolge startend mit der ersten Funktion (f₁) anwendbar sind.

## Claims

1. Method for designing a circuit (10) suitable for generating random bits, wherein
- the circuit (10) has a number m of mapping devices (K1, K2,... Kj,... Ki,... Km);
- each of the mapping devices (K1, K2,... Kj,... Ki,... Km) is supplied a number n of input bits, where n is a value greater than 1;
- each of the mapping devices (K1, K2,... Kj,... Ki,... Km) uses a respective function (f₁, f₂,... fⱼ,... fᵢ,... fₘ) to carry out a bijective mapping of the n input bits to n output bits,
having the following steps:
(a) selection of a j-th mapping device (Kⱼ) from the first mapping device (K₁) to m-th mapping device (Kₘ) and prescribing of a j-th specific function (gⱼ) from a set of bijective mappings as the j-th function (fⱼ), wherein
- a j-th concatenation (fⱼ') of the j functions (f₁, ... fⱼ) carries out a j-th fixed-point-free mapping when the j-th specific function (gⱼ) is prescribed as the j-th function (fⱼ);
- the j-th concatenation applies the j functions in an ascending order starting with the first function (f₁);
(b) selection of at least one i-th mapping device (Kᵢ) from the first mapping device (K₁) to m-th mapping device (Kₘ), where i is not equal to j, and prescribing of an i-th specific function (gᵢ) from a set of bijective mappings as the i-th function (fᵢ), wherein
- an i-th concatenation (fᵢ') of the i functions (f₁,... fᵢ) carries out an i-th fixed-point-free mapping when the i-th specific function (gᵢ) is prescribed as the i-th function (fᵢ);
- the i-th concatenation applies the i functions in an ascending order starting with the first function (f₁).

2. Method according to Claim 1, wherein
- each of the m mapping devices from the first mapping device (K₁) to m-th mapping device (Km) is selected and step (a) or (b) is taken as a basis for prescribing a respective specific function (g₁, g₂,... gⱼ,... gᵢ,... gₘ) as the respective function (f₁, f₂,... fⱼ,... fᵢ,... fₘ).

3. Method according to Claim 1 or 2, wherein the circuit (10) is in the form of a multipath ring oscillator.

4. Apparatus for designing a circuit (10) suitable for generating random bits, wherein
- the circuit (10) has a number m of mapping devices (K₁, K₂,... Kⱼ,... Kᵢ,... Kₘ);
- each of the mapping devices (K₁, K₂,... Kⱼ,... Kᵢ,... Kₘ) obtains a number n of input bits, where n is a value greater than 1;
- each of the mapping devices (K₁, K₂,... Kⱼ,... Kᵢ,... Kₘ) can use a respective function (f₁, f₂,... fⱼ,... fᵢ,... fₘ) to carry out a bijective mapping of the n input bits to n output bits, comprising:
- a j-th unit
for selecting a j-th mapping device (Kⱼ) from the first mapping device (K₁) to m-th mapping device (Kₘ) and
for prescribing a j-th specific function (gⱼ) from a set of bijective mappings as the j-th function (fⱼ), wherein
a j-th concatenation (fⱼ') of the j functions (f₁,... fⱼ) can carry out a j-th fixed-point-free mapping when the j-th specific function (gⱼ) is prescribed as the j-th function (fⱼ) and
the j-th concatenation can apply the j functions in an ascending order starting with the first function (f₁);
- an i-th unit
for selecting at least one further i-th mapping device (Kᵢ) from the first mapping device (K₁) to m-th mapping device (Kₘ), where i is not equal to j, and
for prescribing an i-th specific function (gᵢ) from a set of bijective mappings as the i-th function (fᵢ), wherein
an i-th concatenation (fᵢ') of the i functions (f₁,... fᵢ) can carry out an i-th fixed-point-free mapping when the i-th specific function (gᵢ) is prescribed as the i-th function (fᵢ) and
the i-th concatenation can apply the i functions in an ascending order starting with the first function (f₁).

5. Circuit (10) for generating random bits, wherein
- the circuit (10) has a number m of mapping devices (K₁, K₂, ... Kⱼ,... Kᵢ,... Kₘ);
- each of the mapping devices (K₁, K₂,... Kⱼ,... Kᵢ,... Kₘ) obtains a number n of input bits, where n is a value greater than 1; **characterized in that**
- each of the mapping devices (K₁, K₂,... Kⱼ,... Kᵢ,... Kₘ) can use a respective function (f₁, f₂,... fⱼ,... fᵢ,... fₘ) to carry out a bijective mapping of the n input bits to n output bits;
- a j-th mapping device (Kⱼ) can be selected from the first mapping device (K₁) to m-th mapping device (Kₘ), and a j-th specific function (gⱼ) from a set of bijective mappings can be prescribed as the j-th function (fⱼ), wherein
a j-th concatenation (fⱼ') of the j functions (f₁,... fⱼ) can carry out a j-th fixed-point-free mapping when the j-th specific function (gⱼ) is prescribed as the j-th function (fⱼ) and
the j-th concatenation can apply the j functions in an ascending order starting with the first function (f₁);
- at least one further i-th mapping device (Kᵢ) can be selected from the first mapping device (K₁) to m-th mapping device (Kₘ), where i is not equal to j, and an i-th specific function (gᵢ) from a set of bijective mappings can be prescribed as the i-th function (fᵢ), wherein
an i-th concatenation (fᵢ') of the i functions (f₁,... fᵢ) can carry out an i-th fixed-point-free mapping when the i-th specific function (gᵢ) is prescribed as the i-th function (fᵢ) and
the i-th concatenation can apply the i functions in an ascending order starting with the first function (f₁).

## Revendications

1. Procédé de construction d'un circuit (10) approprié pour générer des bits aléatoires,
- le circuit (10) comportant un nombre m de dispositifs d'application (K₁, K₂, ... Kⱼ, ... Ki, ... Kₘ);
- à chacun des dispositifs d'application (K₁, K₂, ... Kⱼ, ... Kᵢ, ... Kₘ) étant amené un nombre n de bits d'entrée, n étant une valeur supérieure à 1 ;
- une application bijective des n bits d'entrée sur n bits de sortie étant réalisée par chacun des dispositifs d'application (K₁, K₂, ... Kⱼ, ... Kᵢ, ... Kₘ) au moyen d'une fonction respective (f₁, f₂, ... fⱼ,... fᵢ,... fₘ), comportant les étapes suivantes :
(a) sélection d'un j^{ème} dispositif d'application (Kⱼ) parmi les premier dispositif d'application (k₁ au m^{ième} dispositif d'application (Km) et spécification d'une j^{ème} fonction spécifique (gⱼ) à partir d'un ensemble d'applications bijectives en tant que j^{ème} fonction (fⱼ),
- une j^{ème} application sans point fixe étant réalisée par un j^{ème} enchaînement (fⱼ') des j fonctions (f₁, ... fⱼ) lors de la spécification de la j^{ème} fonction spécifique (gⱼ) en tant que j^{ème} fonction (fⱼ) ;
- les j fonctions étant appliquées par le j^{ème} enchaînement en ordre croissant en commençant par la première fonction (f₁) ;
(b) sélection d'au moins un i^{ème} dispositif d'application (Kᵢ) parmi les premier dispositif d'application (K₁) au m^{ième} dispositif d'application (Kₘ), i étant différent de j, et une spécification d'une i^{ème} fonction spécifique (gᵢ) à partir d'un ensemble d'applications bijectives en tant que i^{ème} fonction (fᵢ),
- une i^{ème} application sans point fixe étant réalisée par un i^{ème} enchaînement (fᵢ') des i fonctions (f₁, ... fᵢ) lors de la spécification de la i^{ème} fonction spécifique (gᵢ) en tant que i^{ème} fonction (fᵢ) ;
- les i fonctions étant appliquées par le i^{ème} enchaînement en ordre croissant en commençant par la première fonction (f₁).

2. Procédé selon la revendication 1,
- chacun des m dispositifs d'application étant choisi parmi les premier dispositif d'application (K₁) au m^{ième} dispositif d'application (Kₘ) et une fonction spécifique respective (g₁, g₂, ... gⱼ, ... gᵢ, ... gₘ) étant spécifiée en tant que fonction respective (f₁, f₂, ... fⱼ,... fᵢ,... fₘ) selon les étapes (a) ou (b).

3. Procédé selon la revendication 1 ou 2, le circuit (10) étant réalisé en tant qu'oscillateur en anneau multipistes.

4. Dispositif pour construire un circuit (10) adapté pour générer des bits aléatoires,
- le circuit (10) comportant un nombre de dispositifs d'application (K₁, K₂, ... Kⱼ,... Kᵢ,... Kₘ) ;
- chacun des dispositifs d'application (K₁, K₂, ... Kⱼ,... Kᵢ,... Kₘ) recevant un nombre n de bits d'entrée, n étant une valeur supérieure à 1 ;
- une application bijective des n bits d'entrée sur n bits de sortie pouvant être réalisée par chacun des dispositifs d'application (K₁, K₂, ... Kⱼ,... Kᵢ,... Kₘ) au moyen d'une fonction respective (f₁, f₂, ... fⱼ,... fᵢ,... fₘ), comprenant :
- une j^{ème} unité
pour sélectionner un j^{ème} dispositif d'application (Kⱼ) parmi les premier dispositif d'application (K₁) au m^{ième} dispositif d'application (Kₘ) et
pour spécifier une j^{ème} fonction spécifique (gⱼ) à partir d'un ensemble d'applications bijectives en tant que j^{ème} fonction (fⱼ),
une j^{ème} application sans point fixe pouvant être réalisée par un j^{ème} enchaînement (fⱼ') des j fonctions (f₁, ... fⱼ) lors de la spécification de la j^{ème} fonction spécifique (gⱼ) en tant que j^{ème} fonction (fⱼ) et les j fonctions pouvant être appliquées par le j^{ème} enchaînement en ordre croissant en commençant par la première fonction (f₁) ;
- une i^{ème} unité
pour sélectionner au moins un autre i^{ème} dispositif d'application (Kᵢ) parmi les premier dispositif d'application (K₁) au m^{ième} dispositif d'application (Kₘ), i étant différent de j, et
pour spécifier une i^{ème} fonction spécifique (gᵢ) à partir d'un ensemble d'applications bijectives en tant qu'i^{ème} fonction (fᵢ),
une i^{ème} application sans point fixe pouvant être réalisée par un i^{ème} enchaînement (fᵢ') des i fonctions (f₁, ... fᵢ) lors de la spécification de la i^{ème} fonction spécifique (gᵢ) en tant que i^{ème} fonction (fᵢ) et
les i fonctions pouvant être appliquées par le i^{ème} enchaînement en ordre croissant en commençant par la première fonction (f₁).

5. Circuit (10) pour générer des bits aléatoires,
- le circuit (10) comportant un nombre m de dispositifs d'application (K₁, K₂, ... Kⱼ, ... Kᵢ, ... Kₘ) ;
- chacun des dispositifs d'application (K₁, K₂, ... Kⱼ, ... Kᵢ, ... Kₘ) reçoit un nombre n de bits d'entrée, n étant une valeur supérieure à 1 ;
**caractérisé en ce que**
- une application bijective des n bits d'entrée sur n bits de sortie peut être réalisée par chacun des dispositifs d'application (K₁, K₂, ... Kⱼ,... Kᵢ,... Kₘ) au moyen d'une fonction respective (f₁, f₂,... fⱼ,... fᵢ,... fₘ) ;
- un j^{ème} dispositif d'application (Kⱼ) pouvant être choisi parmi les premier dispositif d'application (K₁) au m^{ième} dispositif d'application (Kₘ) et une j^{ème} fonction spécifique (gⱼ) pouvant être spécifiée en tant que j^{ème} fonction (fⱼ) à partir d'un ensemble d'applications bijectives,
une j^{ème} application sans point fixe pouvant être réalisée par un j^{ème} enchaînement (fⱼ') des j fonctions (f₁, ... fⱼ) lors de la spécification de la j^{ème} fonction spécifique (gⱼ) en tant que j^{ème} fonction (fⱼ) et
les j fonctions pouvant être appliquées par le j^{ème} enchaînement en ordre croissant en commençant par la première fonction (f₁) ;
- au moins un autre i^{ème} dispositif d'application (Kᵢ) pouvant être choisi parmi les premier dispositif d'application (K₁) au m^{ième} dispositif d'application (Km), i étant différent de j, et une i^{ème} fonction spécifique (gᵢ) pouvant être spécifiée en tant que i^{ème} fonction (fᵢ) à partir d'un ensemble d'applications bijectives,
une i^{ème} application sans point fixe pouvant être réalisée par un i^{ème} enchaînement (fᵢ') des i fonctions (f₁, ... fᵢ) lors de la spécification de la i^{ème} fonction spécifique (gᵢ) en tant que i^{ème} fonction (fᵢ) et
les i fonctions pouvant être appliquées par le i^{ème} enchaînement en ordre croissant en commençant par la première fonction (f₁).
